# EUROPEAN PATENT APPLICATION

(11) **EP 2 958 136 A2**
(43) Date of publication of application: **23.12.2015**
(21) Application number: 14751278.4
(22) Date of filing: 16.01.2014
(51) Int. Cl.: H01L 21/60, H01L 27/14

(54) **SEMICONDUCTOR SUBSTRATE, SEMICONDUCTOR DEVICEIMAGE PICKUP DEVICE, AND IMAGING DEVICE**

(30) Priority: 14.02.2013 JP 2013027057
(71) Applicant: Olympus Corporation, Shibuya-ku Tokyo 151-0072 (JP)
(72) Inventor: SAITO Haruhisa, Tokyo 151-0072 (JP); TADAKI Yoshitaka, Tokyo 151-0072 (JP); MIGITA Chihiro, Oume-shi Tokyo 198-8512 (JP)
(74) Representative: Gunzelmann, Rainer
(86) International application number: PCT/JP2014/050655
(87) International publication number: WO 2014/125861

(57) **Abstract**

A semiconductor substrate includes a semiconductor substrate body (12d) in which a wiring (16) is formed and a bonding electrode (12a) provided to protrude from a first surface (12c) of the semiconductor substrate body (12d). The bonding electrode (12a) comprises a composite including a first metal portion (14) which is provided to protrude from the first surface (12c) of the semiconductor substrate body (12d) and of which a base end portion in a protrusion direction is electrically connected to the wiring (16), and a second metal portion (15) which is formed of a second metal harder than first metal of which the first metal portion (14) is formed and which is provided to be bonded to the first metal portion (14) in a range equal to or less than a protrusion height of the first metal portion (14).

## Description

### Technical Field

The present invention relates to a semiconductor substrate, a semiconductor device, an imaging element, and an imaging device. Priority is claimed on Japanese Patent Application No. 2013-027057, filed on February 14, 2013, the content of which is incorporated herein by reference.

### Background Art

In the related art, as methods of electrically connecting semiconductor device wafers to each other, there are methods of performing heating or pressure-bonding using solder bumps or metal bumps to connect semiconductor device wafers. These methods have been put into use as technologies for mounting semiconductor chips.

However, in recent years, since semiconductor devices are required to be miniaturized, pitches of bonding electrodes have been become narrower and narrower. In the present technologies for forming solder bumps, it is difficult to form solder bumps with sizes of a few µm. For this reason, connection methods using solder bumps may not be appropriate for such miniaturization since there is a possibility of electrodes being short-circuited at the time of bonding.

Even in connection methods of performing heating and pressure-bonding using metal bumps, the metal bumps are required to be minute to correspond to the narrower pitches of the bonding electrodes. Accordingly, the heights of the metal bumps also become minute. Therefore, pressurizing force when the substrates are pressurized is easily causing uneven due to such as variations in the heights of the metal bumps from manufacturing errors and errors in degrees to which semiconductor substrates are level and parallel. As a result, connector failures easily occur. However, when the pressurizing force is increased to control connection failures, damage easily occurs due to the pressurization on semiconductor devices.

As a technology related to an improvement in the pressurization irregularity, Patent Document 1 discloses a technology for performing an electrical connection providing a conductive member which connects a second conductive member, in which gold plating or the like is performed on a surface of an elastic member formed of a resin such as an acrylic resin and molded in a substantially semi-cylindrical shape (a dome shape of which a semi-circular cross-sectional surface extends in one direction), with an output terminal of a driver IC of a liquid crystal panel or the like and contacting the conductive member with an electrode pad.

### Prior Art Document

### Patent Document

[Patent Document 1]
   Japanese Unexamined Patent Application, First Publication No. 2007-258518

### Disclosure of Invention

### Problems to be Solved by the Invention

In the technology disclosed in Patent Document 1, the elastic member formed of a resin is elastically deformed at the time of bonding. For this reason, the variations in the heights of the conductive members or the errors in the degrees to which the semiconductor substrates are level and parallel can be absorbed by the elastic deformation, but it is difficult for the elastic member formed of a resin to realize the minuteness of the bonding electrode with high precision.

That is, this technology is, for example, a technology applicable when the number of output terminals is small and the pitches of the bonding electrodes are broad as in a driver IC. For example, it is difficult to apply the technology to bonding between a vast number of minute bonding electrodes arranged at considerably narrow pitches, such as connection of stacked semiconductor substrates of imaging elements.

In the technology disclosed in Patent Document 1, the elastic deformation is used. Therefore, even when the technology is applied to minute bonding electrodes, it is difficult to maintain the deformed shape at the time of bonding after the bonding.

Since a resin is used as the elastic member, cracking occurs in the second conductive member or splitting occurs in the second conductive member when the deformation is too great. For this reason, characteristics deteriorating over time or bonding failures may occur.

Since the second conductive member is thinned in accordance with advances in minuteness, the second conductive member is considerably lacking in strength.

The present invention was devised in view of the foregoing circumstances and an object of the present invention is to provide a semiconductor substrate, a semiconductor device, an imaging element, and an imaging device capable of limiting damage caused due to pressurization when the electrodes are bonded and successfully maintaining deformed shapes and connection states when electrodes are bonded. Means for Solving the Problems

According to a first aspect of the present invention, a semiconductor substrate includes: a semiconductor substrate body in which a wiring is formed; and a bonding electrode provided to protrude from a first surface of the semiconductor substrate body. The bonding electrode comprises a composite including a first metal portion which is provided to protrude from the first surface of the semiconductor substrate body and of which a base end portion in a protrusion direction is electrically connected to the wiring, and a second metal portion which is formed of a second metal harder than first metal of which the first metal portion is formed and which is provided to be bonded to the first metal portion in a range equal to or less than a protrusion height of the first metal portion.

According to a second aspect of the present invention, in the semiconductor substrate according to the first aspect of the invention, the second metal portion may be covered with the first metal portion at a tip end portion of the bending electrode in the protrusion direction.

According to a third aspect of the present invention, in the semiconductor substrate according to the first or second aspect of the invention, the bonding electrode may be formed by the first metal portion at an entire surface protruding from the first surface of the semiconductor substrate body.

According to a fourth aspect of the present invention, in the semiconductor substrate according to any one of the first to third aspects of the invention, the second metal may be aluminum and the first metal may be gold or copper.

According to a fifth aspect of the present invention, in the semiconductor substrate according to any one of the first to third aspects of the invention, the second metal may be gold and the first metal may be copper.

According to a sixth aspect of the present invention, in the semiconductor substrate according to any one of the first to third aspects of the invention, the second metal may be indium and the first metal may be a metal selected from gold, copper, and aluminum.

According to a seventh aspect of the present invention, in the semiconductor substrate according to any one of the first to sixth aspects of the invention, the second metal portion may be bonded to the first metal portion via a barrier metal layer.

According to an eighth aspect of the present invention, a semiconductor device includes: the semiconductor substrate according to any one of the first to seventh aspects of the invention; and a bonded member bonded via the bonding electrode of the semiconductor substrate.

According to a ninth aspect of the present invention, an imaging element includes the semiconductor substrate according to any one of the first to seventh aspects of the invention.

According to a tenth aspect of the present invention, an imaging device includes the image sensor according to the ninth aspect of the invention.

### Effect of the Invention

In the semiconductor substrate, the semiconductor device, the imaging element, and the imaging device according to the foregoing aspects, the composite including the first metal portion and the second metal portion formed of metals that differ in hardness is used as the bonding electrode. Therefore, it is possible to limit damage due to the pressurization at the time of the bonding and successfully maintain the deformed shape and the connection state at the time of the bonding.

### Brief Description of the Drawings

Fig. 1 is a system configuration diagram showing a system configuration of an imaging device according to an embodiment of the present invention.
Fig. 2A is a plan view showing an imaging element according to the embodiment of the present invention.
Fig. 2B is a sectional view taken along the line A-A of Fig. 2A.
Fig. 2C is a diagram showing the details of a portion B in the sectional view taken along the line A-A of Fig. 2A.
Fig. 3 is a schematic sectional view showing a bonding state of bonding electrodes in the imaging element according to the embodiment of the present invention.
Fig. 4A is a schematic plan view showing the bonding electrode of a semiconductor substrate according to the embodiment of the present invention.
Fig. 4B is a sectional view taken along the line C-C of Fig. 4A.
Fig. 5A is a schematic plan view showing a bonding electrode of a semiconductor substrate according to a first modified example of the embodiment of the present invention.
Fig. 5B is a sectional view taken along the line D-D of Fig. 5A.
Fig. 6A is a schematic plan view showing a bonding electrode of a semiconductor substrate according to a second modified example of the embodiment of the present invention.
Fig. 6B is a sectional view taken along the line E-E of Fig. 6A.
Fig. 7 is a schematic partial sectional view showing a bonding electrode of a semiconductor substrate according to a third modified example of the embodiment of the present invention.
Fig. 8 is a schematic sectional view showing a bonding electrode of a semiconductor substrate according to a fourth modified example of the embodiment of the present invention.
Fig. 9A is a schematic plan view showing a bonding electrode of a semiconductor substrate according to a fifth modified example of the embodiment of the present invention.
Fig. 9B is a sectional view taken along the line F-F of Fig. 9A.

### [Description of Embodiments]

A semiconductor substrate, a semiconductor device, an imaging element, and an imaging device according to an embodiment of the present invention will be described.

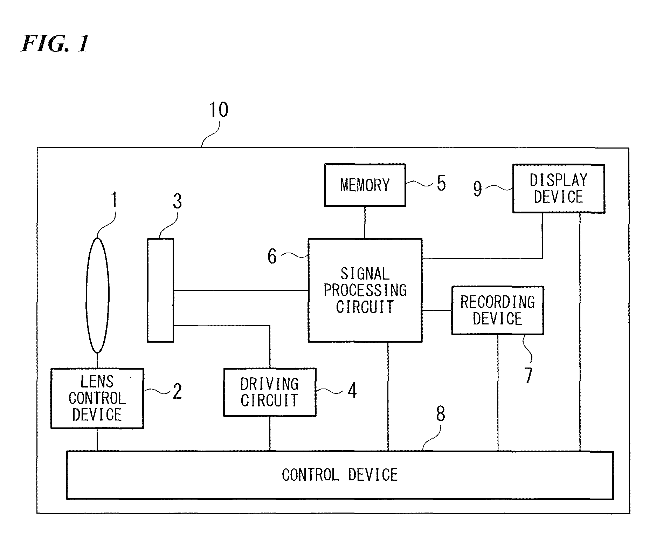

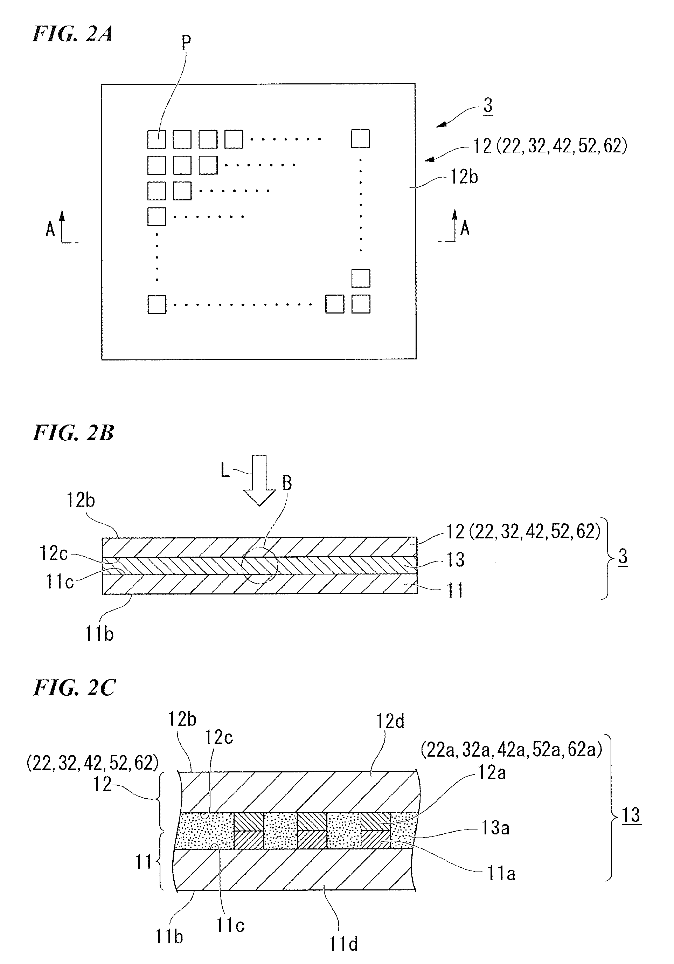

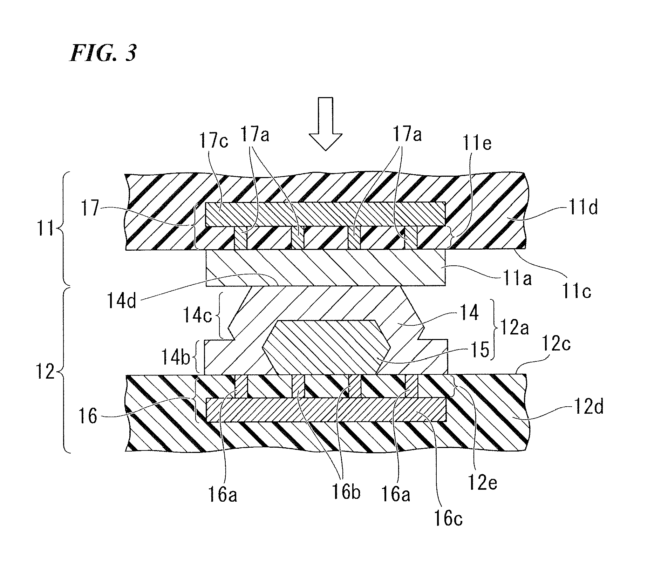

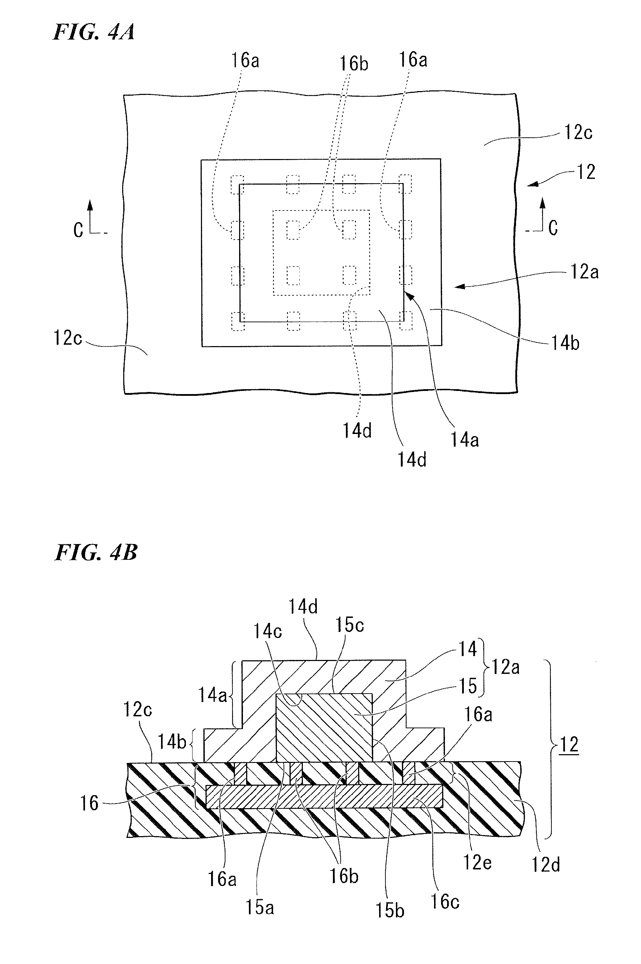

Fig. 1 is a system configuration diagram showing a system configuration of an imaging device according to an embodiment of the present invention. Fig. 2A is a plan view showing an imaging element according to the embodiment of the present invention. Fig. 2B is a sectional view taken along the line A-A of Fig. 2A. Fig. 2C is a diagram showing the details of a portion B in Fig. 2B. Fig. 3 is a schematic sectional view showing a bonding state of bonding electrodes in the imaging element according to the embodiment of the present invention. Fig. 4A is a schematic plan view showing the bonding electrode of a semiconductor substrate according to the embodiment of the present invention. Fig. 4B is a sectional view taken along the line C-C of Fig. 4A.

Since the drawings are schematic diagrams, shapes or dimensions are exaggerated (the same applies to subsequent drawings).

An imaging device according to an aspect of the present invention may be an electronic apparatus that has an imaging function, for example, a digital video camera, an endoscope, or the like as well as a digital camera. In the embodiment, a case in which the imaging device is, for example, a digital camera will be described.

As shown in Fig. 1, a digital camera 10 (imaging device) according to the embodiment includes a lens unit 1, a lens control device 2, a solid-state imaging element 3 (an imaging element or a semiconductor device), a driving circuit 4, a memory 5, a signal processing circuit 6, a recording device 7, a control device 8, and a display device 9.

The lens unit 1 includes, for example, a zoom lens or a focus lens and images light from a subject as a subject image on a light reception surface of the solid-state imaging element 3. The lens control device 2 controls zoom, focus, a diaphragm, and the like of the lens unit 1. The light received via the lens unit 1 is imaged on the light reception surface of the solid-state imaging element 3.

The solid-state imaging element 3 converts the subject image imaged on the light reception surface into an image signal and outputs the image signal. On the light reception surface of the solid-state imaging element 3, a plurality of pixels are arranged 2-dimensionally in row and column directions. The detailed configuration of the solid-state imaging element 3 will be described below.

The driving circuit 4 drives the solid-state imaging element 3 and controls an operation of the solid-state imaging element 3. The memory 5 temporarily stores image data. The signal processing circuit 6 performs pre-decided processes in accordance with the image signal output from the solid-state imaging element 3. Examples of the processes performed by the signal processing circuit 6 include amplification of the image signal, various kinds of correction of the image data, and compression of the image data.

The recording device 7 includes a semiconductor memory for recording or writing the image data and is equipped to be detachably mounted on the digital camera 10. For example, the display device 9 displays a moving image (live-view image), displays a still image, displays a moving image or a still image recorded on the recording device 7, or displays a state of the digital camera 10.

The control device 8 controls the entire digital camera 10. An operation of the control device 8 is defined in a program stored in a ROM included in the digital camera 10. The control device 8 reads the program and performs various kinds of control according to content defined by the program.

Next, the detailed configuration of the solid-state imaging element 3 will be described.

As shown in Figs. 2A and 2B, the solid-state imaging element 3 has a rectangular exterior in a plan view and is configured from a stacked semiconductor device in which a first substrate 12 (semiconductor substrate) and a second substrate 11 (bonded member) are bonded together.

In the middle portion of a first surface 12b which is a surface of the first substrate 12 facing the outside of the device, light-receiving portions P formed from a plurality of photodiodes corresponding to pixels of photoelectric conversion are formed at intervals. In the embodiment, the light-receiving portions P are arrayed in a 2-dimensional lattice form in arrangement directions parallel to the longer sides (which are sides extending in the horizontal direction as shown in Fig. 2A) and shorter sides (which are sides extending the vertical direction as shown in Fig. 2A) of the exterior of the solid-state imaging element 3 in the plan view.

Although not shown to avoid complicating the drawing, an on-chip color filter that performs color separation on incident light L (see Fig. 2B) to obtain an image of a subject or an on-chip microlens that condenses the incident light L on the light-receiving portion P is formed on each light-receiving portion P. Outside a region in which the light-receiving portions P are arrayed, a light-shielding film is provided, as necessary, to shield unnecessary light which is likely to become image noise.

As shown in Fig. 2B, the first substrate 12, a bonding layer portion 13, and a second substrate 11 are stacked in this order in the cross-sectional configuration of the solid-state imaging element 3 in the thickness direction.

As shown in Fig. 2C, the first substrate 12 includes a substrate body 12d (semiconductor substrate body) and a plurality of bonding electrodes 12a that are bonded to the second substrate 11 for electric connection. A semiconductor device including a circuit unit in which a diffusion layer or wirings of a single layer or a plurality of layers are formed on a wafer substrate through a semiconductor manufacturing process is formed in the substrate body 12d. The bonding electrodes 12a are provided on a second surface 12c (which is a first surface of the semiconductor substrate body) opposite to the first surface 12b of the substrate body 12d.

The second substrate 11 includes a substrate body 11 d (semiconductor substrate body) and a plurality of bonding electrodes 12a that are bonded to the first substrate 12 for electric connection. A semiconductor device including a circuit unit in which a diffusion layer or wirings of a single layer or a plurality of layers are formed on a wafer substrate through a semiconductor manufacturing process is formed in the substrate body 11d. The bonding electrodes 11a are provided on a first surface 11c, which is one surface (first surface) of the substrate body 11d in the thickness direction, at positions facing the bonding electrodes 12a of the first substrate 12 to be in close contact with and bonded to the bonding electrodes 12a.

A second surface 11b of the substrate body 11d on the rear surface side of the first surface 11c faces the device outside in the solid-state imaging element 3, and thus forms the surface of the solid-state imaging element 3 on the opposite side to the first surface 12b. The second surface 12c and the first surface 11c face each other via the bonding layer portion 13.

As the circuit units formed in the substrates bodies 12d and 11d, for example, circuit units such as driving circuits including wirings, electrodes, and circuit elements to transmit charges generated in the right-receiving portion P and extract an image signal can be exemplified.

Although not shown, the circuit units are appropriately distributed and arrayed in the substrate bodies 12d and 11d.

The bonding electrodes 12a and 11a are connected to the wirings of the circuit units (not shown) distributed in the substrate bodies 12d and 11d and electrically connect the circuit units.

As shown in Fig. 2C, the bonding layer portion 13 is formed in a gap formed when the second surface 12c of the substrate body 12d faces the first surface 11c of the substrate body 11d.

The bonding layer portion 13 includes the bonding electrodes 11a which are provided on the first surface 11c of the second substrate 11, the bonding electrodes 12a which are provided on the second surface 12c of the first substrate 12, and an adhesive layer 13a which is solidified after filling the gap between the first surface 11c and the second surface 12c is filled and bonds the second substrate 11 and the first substrate 12 to each other.

Fig. 3 shows a schematic cross-sectional surface of the bonding electrodes 11a and 12a in the bonded state and the vicinities thereof. In the diagram shown in Fig. 3, the vertical positional relation is reversed from that of Fig. 2C.

In the embodiment, the bonding electrodes 11a and 12a are provided to protrude from the first surface 11c and the second surface 12c, respectively, and come in contact with each other at tip ends thereof in protrusion directions.

The bonding electrode 12a is easily plastically deformed by welding pressure at the time of the bonding, so that a protrusion height is changed. Fig. 3 schematically shows an example of the shape of the bonding electrode 12a after being deformed.

The bonding electrode 11a configures a layered bonding pad and is formed as a metal layer, which has a broader size than the tip end of the bonding electrode 12a, on the second surface 11b, as shown in detail in Fig. 3.

As the material of the bonding electrode 11a, an appropriate metal used for the electrode of the semiconductor substrate, for example, a metal including aluminum, gold, silver, copper, nickel, platinum, tungsten, or titanium, can be adopted.

In the present specification, the term "metal" is used in a broad sense and includes pure metals formed from metal elements and alloys with conductivity including a plurality of metal elements, unless otherwise mentioned. Therefore, for example, when the metal is simply referred to as "aluminum," the aluminum may be pure aluminum or may be an aluminum alloy unless otherwise mentioned.

A wiring portion 17 (wiring) forming a part of the circuit unit (not shown) of the substrate body 11d is provided inside the substrate body 11d near a lower layer side (an upper side shown in Fig. 3) of the bonding electrode 11a.

The wiring portion 17 includes a patterned wiring body 17c and a plurality of columnar connection portions 17a electrically connecting the bonding electrode 11a to the wiring body 17c located on the lower layer side (the upper side shown in Fig. 3) of the bonding electrode 11a.

Therefore, the connection portions 17a are provided to penetrate through an insulation layer 11e stacked between the bonding electrode 11a and the wiring body 17c.

The array positions and the number of connection portions 17a are not particularly limited as long as the connection portions 17a electrically connect the bonding electrode 11a to the wiring body 17c.

As the materials of both of the wiring body 17c and the connection portions 17a, for example, appropriate metals used for wirings of the semiconductor substrate, for example, metals formed from aluminum, copper, and tungsten, can be adopted.

The wiring portion 17 may be formed in a plurality of layers.

Next, the configuration of the bonding electrode 12a will be described based on the shape before the plastic deformation.

As shown in Figs. 4A and 4B, the bonding electrode 12a is a protrusion which is provided on the second surface 12c and has conductivity. In the embodiment, the bonding electrode 12a is consisted of a composite of a second metal portion 15 and a first metal portion 14. The second metal portion 15 has a rectangular parallelepiped shape which is formed so that a bottom surface 15a is in close contact with the second surface 12c. The first metal portion 14 protrudes from the second surface 12c on the outer circumference of the second metal portion 15 and is formed to cover a side surface 15b and a top surface 15c of the second metal portion 15.

Therefore, the first metal portion 14 includes a protrusion-shaped portion 14a and a wiring connection portion 14b which has rectangular shape in a plan view. The wiring connection portion 14b is in close contact with the second surface 12c in a range surrounding the side of the second metal portion 15 at the base end in the protrusion direction. The protrusion-shaped portion 14a is formed on the wiring connection portion 14b to protrude in a square columnar shape smaller than the external shape of the wiring connection portion 14b in plan view.

A tip end surface 14d of the protrusion-shaped portion 14a in the protrusion direction has a rectangular shape in a plan view and substantially parallel to the second surface 12c (including a parallel case). When the first metal portion 14 is bonded to the second substrate 11, the tip end surface 14d is a portion being contacted with and being bonded to the bonding electrode 11a of the second substrate 11.

An inner wall portion 14c of the first metal portion 14 has a rectangular hole shape that has a bottom and is in close contact with the side surface 15b and the top surface 15c of the second metal portion 15.

As materials used for the first metal portion 14 and the second metal portion 15, an appropriate metal usable in a semiconductor manufacturing process can be adopted.

As a first metal of which the first metal portion 14 is formed, for example, aluminum (HV25, melting point: 660°C), gold (HV26, melting point: 1063°C), silver (HV26, melting point: 961°C), copper (HV46, melting point: 1083°C), nickel (HV96, melting point: 1453°C), platinum (HV41, melting point: 1769°C), tungsten (HV100 to 350, melting point: 3380°C), and titanium (HV120, melting point: 1668°C) can be appropriately used. Here, HV indicates the Vickers hardness. The melting points are the melting points of pure metals.

As a second metal of which the second metal portion 15 is formed, the metals usable for the first metal portion 14 and a metal with lower hardness than the first metal used in the first metal portion 14 can be adopted..

When the second metal has a lower hardness than the first metal used for the first metal portion 14, a metal with low hardness that is not appropriate as the first metal can also be adopted.

Since the hardness of metal is changed due to heat treatment, the same metal as the first metal used for the first metal portion 14 can also be used as the second metal. In this case, after the second metal portion 15 is formed, heat treatment is performed to reduce the hardness, and then the first metal portion 14 is formed so that a composite with different kinds of hardness can be formed.

Preferable examples of the second metal are aluminum, gold, silver, copper, nickel, platinum, tungsten, and titanium, like the first metal.

Preferable Examples of the metal with low hardness as the second metal are indium (melting point of 157°C), tin (melting point of 231 °C), and a tin solder alloy (melting point of 231°C).

The Vickers hardness of the metal with low hardness is different depending on temperature, but the second metal can be combined with any of the metal groups preferable for the foregoing first metal.

As an example of the combination of the materials of the first metal portion 14 and the second metal portion 15, the first metal can be selected from gold, silver, copper, nickel, and tungsten, for example, when aluminum is adopted as the second metal. Of these materials, gold or copper is more preferable.

When gold is adopted as the second metal, a metal selected from silver, copper, nickel, and tungsten can be adopted as the first metal. Of these materials, copper is particularly preferable.

When indium is adopted as the second metal, a metal selected from gold, copper, and aluminum is more preferable as the first metal.

The dimensions of each of the first metal portion 14 and the second metal portion 15 are set to dimensions in which the hardness of the bonding electrode 12a which is the composite satisfies conditions necessary when the first substrate 12 is bonded to the second substrate 11.

That is, same as in the related art, the outer appearance of the bonding electrode 12a is decided depending on, for example, the arrangement intervals of the bonding electrodes 12a, the size of the bonding electrode 11a which is a bonding counterpart, a preferable substrate distance between the substrate bodies 12d and 11d, and so on.

The hardness of the bonding electrode 12a is set as hardness at which the bonding electrode 12a can be plastically deformed to the maximum deformation amount in accordance with a variation in a manufacturing error at the time of bonding to the second substrate 11 by an allowable welding pressure that does not damage the semiconductor device or the like of the second substrate 11 and the first substrate 12.

Here, as the variation in the manufacturing error at the time of bonding, for example, a manufacturing variation in the protrusion height of the bonding electrode 12a, an error in the degree to which the second substrate 11 and the first substrate 12 are level, and an error in the degree to which the second substrate 11 and the first substrate 12 are parallel at the time of pressurization are exemplified. That is, such manufacturing errors to cause gaps between some of the bonding electrodes 11a and 12a. For this reason, to electrically connect all of the bonding electrodes 11a and 12a, the other bonding electrodes 11a after the contact need to be deformed until the gaps disappear.

Accordingly, the hardness is adjusted so that the bonding electrodes 12a are deformed to the necessary maximum deformation amount within the range of the allowable welding pressure.

The hardness of the bonding electrode 12a can be appropriately adjusted by changing a ratio of the second metal portion 15 with low hardness to the first metal portion 14 with high hardness. For example, when the thickness of the protrusion-shaped portion 14a is gradually decreased, the volume of the second metal portion 15 is increased relatively with respect to the volume of the first metal portion 14. Therefore, it is possible to reduce the hardness of the bonding electrode 12a which is a composite.

Specifically, for example, it is possible to decide a detailed shape in which necessary hardness is realized by performing deformation analysis by numerical calculation. At this time, instead of entirely changing the thickness of the protrusion-shaped portion 14a, the thickness can also be partially changed.

A wiring portion 16 (wiring) forming a part of the circuit unit (not shown) of the substrate body 12d is provided inside the substrate body 12d on the lower layer side of the bonding electrode 12a with such a configuration.

The wiring portion 16 includes a patterned wiring body 16c and a plurality of columnar connection portions 16a and 16b electrically connecting the wiring body 16c located on the lower layer side of the bonding electrode 12a to the bonding electrode 11 a.

The connection portions 16a are portions at where the wiring body 16c and the first metal portion 14 are electrically connected. The connection portions 16a are provided to penetrate through an insulation layer 12e stacked between the wiring connection portion 14b and the wiring body 16c.

The connection portions 16b are portions at where the wiring body 16c and the second metal portion 15 are electrically connected. The connection portions 16b are provided to penetrate through the insulation layer 12e stacked between the bottom surface 15a of the second metal portion 15 and the wiring body 16c.

Neither the array positions nor the numbers of connection portions 16a and 16b are particularly limited as long as the connection portions 16a and 16b electrically connect the first metal portion 14 and the second metal portion 15 to the wiring body 16c. In the embodiment, for example, as indicated by dotted lines in Fig. 4A, a total of 12 connection portions 16a are arranged in a rectangular form and a total of 4 connection portions 16b are arranged in a rectangular form in a middle portion of the rectangle of the connection portions 16a.

As the materials of both the wiring body 16c and the connection portions 16a and 16b, for example, metals formed from tungsten and aluminum can be adopted.

In such a configuration, each connection portion 16a is electrically connected to the first metal portion 14 via the wiring connection portion 14b of the first metal portion 14. Each connection portion 16b is electrically connected to the second metal portion 15 via the bottom surface 15a of the second metal portion 15.

The first metal portion 14 and the second metal portion 15 are electrically connected to each other between the inner wall portion 14c, and the side surface 15b and the top surface 15c.

The bonding electrode 12a can be manufactured by forming the circuit unit and the wiring portion 16 in the first substrate 12 through a semiconductor manufacturing process, subsequently forming the second metal portion 15 on the connection portion 16b, and then forming the first metal portion 14.

For example, a metal layer formed of the second metal may be formed on the second surface 12c through, for example, sputtering, evaporation, or plating, and then, a pattern of the second portion 15 may be formed through photolithography for forming the second metal portion 15.

A metal layer formed of the first metal may be formed on the second surface 12c and the second metal portion 15 through, for example, sputtering or evaporation, and then, a pattern of the first metal portion 14 may be formed through photolithography for forming the first metal portion 14.

For example, the solid-state imaging element 3 is manufactured by a following process. The second substrate 11 and the first substrate 12 are manufactured through, a semiconductor manufacturing process and a surface activation process is subsequently performed on the first surface 11c and the second surface 12c including the bonding electrodes 11a and 12a.

Next, the second substrate 11 and the first substrate 12 are caused to face each other by performing alignment so that the respective bonding electrodes 12a face the corresponding bonding electrodes 11a. Then, the second substrate 11 and the first substrate 12 are pressurized in the facing directions while the bonding electrodes 11a and 12a are heated under a vacuum atmosphere or an air atmosphere.

At this time, in general, a variation may occur in the contact state between the bonding electrodes 11a and 12a due to, for example, a manufacturing variation in the protrusion height of the bonding electrode 12a, an error in the degree to which the second substrate 11 and the first substrate 12 are level, and an error in the degree to which the second substrate 11 and the first substrate 12 are parallel at the time of pressurization,.

However, in the embodiment, the bonding electrode 12a is formed as the composite of the second metal portion 15 with the low hardness and the first metal portion 14 with the high hardness. Therefore, the earlier contacted bonding electrode 12a can be deformed by the lower welding pressure than when all of the bonding electrodes 12a are formed of the first metal, and then, all of the bonding electrodes 12a can be brought in contact with the facing bonding electrodes 11a by a pressure in the range of the allowable welding pressure.

Since the tip end portions of the bonding electrodes 12a and 11a in close contact with each other are subjected to a surface activation process, the bonding electrodes 12a and 11a is strongly bonded.

Even when the welding pressure is cancelled, the deformed state can be maintained since the bonding electrode 12a with the low hardness is easily plastically deformed. Thus, the change in the gap between the first surface 12b and the second surface 11b can be limited.

At this time, in the first metal portion 14 with the relatively higher hardness, cracking or splitting occurs depending on the magnitude of stress. However, as shown in Fig. 3, the inner wall portion 14c is in close contact with the entire surface of the second metal portion 15 on the upper side of the second surface 12c. Therefore, even when cracking or splitting occurs in the first metal portion 14, it is possible to prevent the first metal portion 14 from being separated from the second metal portion 15.

Accordingly, even when a part of the first metal portion 14 is in a disconnected state, the electrically connected state between the first metal portion 14 and the second metal portion 15 is not changed. Therefore, the bonding electrode 12a is not in the disconnected state and the change in connection resistance is also limited.

Since the inner wall portion 14c is in close contact with the entire surface on the upper side of the second surface 12c of the second metal portion 15, the second metal portion 15 is restrained in an isotropic manner. Therefore, the bonding electrode 12a is unlikely to incline in a specific direction when the bonding electrode 12a is deformed.

Accordingly, since a force sufficient to shift the second substrate 11 and the first substrate 12 in a direction intersecting the facing direction at the time of the pressurization when the bonding electrodes are bonded is unlikely to occur, position shift of the second substrate 11 and the first substrate 12 in the direction intersecting the facing direction can be limited. As a result, even when the bonding electrodes 12a and 11 a are arrayed at narrow pitches, the bonding electrodes 12a and 11a can be bonded successfully.

When the pressurization ends in this way, the gap between the first surface 12b and the second surface 11b is filled with the adhesive layer 13a to be solidified.

Thereafter, the solid-state imaging element 3 is manufactured by performing scribing, as necessary.

In the first substrate 12 according to the embodiment, the composite including the first metal portion 14 and the second metal portion 15 formed of metals that differ in hardness is used as the bonding electrode 12a. Therefore, it is possible to limit damage caused due to the pressurization at the time of bonding the first substrate 12 to the second substrate 11 and successfully maintain the deformed shape and the connection state at the time of the bonding.

Since the bonding electrodes 12a can be formed through the semiconductor manufacturing process, the bonding electrodes 12a can be formed minutely and can be provided with high precision even in a semiconductor substrate in which wiring intervals are narrow. Therefore, for example, the first substrate 12 is suitable as a semiconductor substrate for manufacturing a semiconductor device with high wiring density and in which a plurality of bonding electrodes are necessary, such as the solid-state imaging element 3.

### [First modified example]

Next, a semiconductor substrate according to a first modified example of the embodiment will be described.

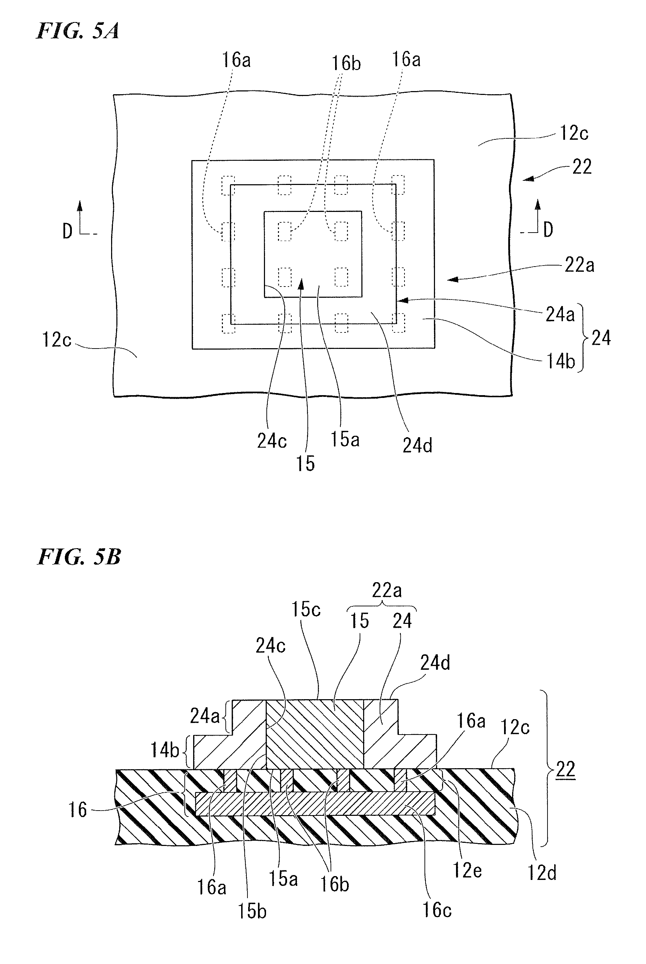

Fig. 5A is a schematic plan view showing a bonding electrode of the semiconductor substrate according to the first modified example of the embodiment of the present invention. Fig. 5B is a sectional view taken along the line D-D of Fig. 5A.

As shown in Figs. 2A and 2B, a first substrate 22 according to the modified example is a semiconductor substrate which can be used for the solid-state imaging element 3, instead of the first substrate 12 according to the foregoing embodiment.

The first substrate 22 includes a bonding electrode 22a instead of the bonding electrode 12a of the first substrate 12 according to the foregoing embodiment.

Hereinafter, differences from the foregoing embodiment will be mainly described.

As indicated in a shape before deformation in Figs. 5A and 5B, the bonding electrode 22a includes a first metal portion 24 instead of the first metal portion 14 of the bonding electrode 12a according to the foregoing embodiment.

The first metal portion 24 includes a protrusion-shaped portion 24a instead of the protrusion-shaped portion 14a of the first metal portion 14 according to the foregoing embodiment. The protrusion-shaped portion 24a is different in that the protrusion-shaped portion 24a has a shape in which the portion on the upper side of the top surface 15c of the second metal portion 15 of the protrusion-shaped portion 14a is removed. The protrusion-shaped portion 24a is formed of the same first metal as the first metal portion 14.

Therefore, a tip end surface 24d which is a tip end portion of the first metal portion 24 in the protrusion direction is aligned with the top surface 15c of the second metal portion 15, and thus the height from the second surface 12c is the same as the top surface 15c and is substantially parallel (or parallel) to the second surface 12c.

The height from the second surface 12c to the tip end surface 24d is a height necessary at the time of the bonding and is, for example, the same height as the height from the second surface 12c to the tip end surface 14d in the bonding electrode 12a.

The rectangular shape of the tip end surface 24d in a plan view is a corner ring shape circling the outer circumference of the top surface 15c.

When the first metal portion 24 is bonded to the second substrate 11, the tip end surface 24d is a portion being contacted with and being bonded to the bonding electrode 11 a of the second substrate 11 along with the top surface 15c of the second metal portion 15.

An inner wall portion 24c with a rectangular hole shape of the first metal portion 24 is in close contact with the side surface 15b of the second metal portion 15.

In the bonding electrode 22a with such a configuration, only the shape of the first metal portion 24 is different from that of the first metal portion 14 of the bonding electrode 12a according to the foregoing embodiment. Therefore, the hardness of the bonding electrode 22a can be adjusted by changing the shapes or volumes of the second metal portion 15 and the first metal portion 24 as in the bonding electrode 12a, and thus the bonding electrode 22a can be formed through the same semiconductor manufacturing process as the bonding electrode 12a.

As in the foregoing embodiment, the first metal portion 24 can be bonded to the second substrate 11.

In the first substrate 22 according to the modified example, a composite including the first metal portion 14 and the second metal portion 15 formed of metals that differ in hardness is used as the bonding electrode 22a. Therefore, in the first substrate 22, it is possible to limit damage caused due to the pressurization at the time of the bonding to the second substrate 11 and successfully maintain the deformed shape and the connected state at the time of the bonding.

Since the bonding electrodes 22a can be formed through the semiconductor manufacturing process, the bonding electrodes 22a can be formed minutely and can be provided with high precision even in a semiconductor substrate in which wiring intervals are narrow. Therefore, for example, the first substrate 22 is suitable as a semiconductor substrate for manufacturing a semiconductor device with high wiring density and in which a plurality of bonding electrodes are necessary, such as the solid-state imaging element 3.

In the bonding electrode 22a according to the modified example, the top surface 15c is not covered with the first metal and is exposed to the tip end portion of the bonding electrode 22a. Therefore, in the second metal portion 15 according to the modified example, the restraint received from the first metal portion 24 is looser than in the case of the foregoing embodiment.

Therefore, when the same degree of hardness as the bonding electrode 12a is obtained, the thickness of the protrusion-shaped portion 24a of the first metal portion can be thicker than the thickness of the protrusion-shaped portion 14a according to the foregoing embodiment.

Since the inner wall portion 24c is in close contact with the side surface 15b of the second metal portion 15, the second metal portion 15 is restrained in an isotropic manner in the planar direction of the second surface 12c. Therefore, the bonding electrode 22a is unlikely to incline in a specific direction when the bonding electrode 22a is deformed.

Accordingly, since a force sufficient to shift the second substrate 11 and the first substrate 22 in a direction intersecting the facing direction at the time of the pressurization when the bonding electrodes are bonded is unlikely to occur, position shift of the second substrate 11 and the first substrate 22 in the direction intersecting the facing direction can be limited. As a result, even when the bonding electrodes 22a and 11a are arrayed at narrow pitches, the bonding electrodes 22a and 11 a can be bonded successfully.

### [Second modified example]

Next, a semiconductor substrate according to a second modified example of the embodiment will be described.

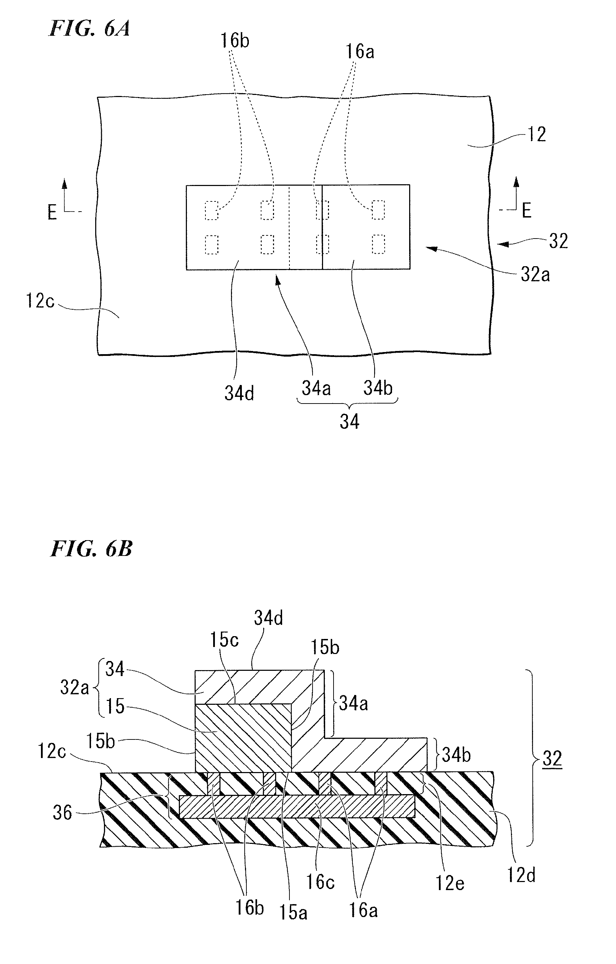

Fig. 6A is a schematic plan view showing a bonding electrode of the semiconductor substrate according to the second modified example of the embodiment of the present invention. Fig. 6B is a sectional view taken along the line E-E of Fig. 6A.

As shown in Figs. 2A and 2B, a first substrate 32 according to the modified example is a semiconductor substrate which can be used for the solid-state imaging element 3, instead of the first substrate 12 according to the foregoing embodiment.

The first substrate 32 includes a bonding electrode 32a instead of the bonding electrode 12a of the first substrate 12 according to the foregoing embodiment.

Hereinafter, differences from the foregoing embodiment will be mainly described.

The shape of the bonding electrode 32a before deformation is shown in Figs. 6A and 6B. The bonding electrode 32a before deformation includes a first metal portion 34 instead of the first metal portion 14 of the bonding electrode 12a according to the foregoing embodiment.

The first metal portion 34 protrudes from the second surface 12c and is formed to cover the top surface 15c and one of the side surface 15b of the second metal portion 15.

That is, the first metal portion 34 includes a wiring connection portion 34b and a protrusion-shaped portion 34a. The wiring connection portion 34b is formed in a rectangular shape which is in close contact with the second surface 12c where is one side of the side surface 15b and extends at the base end portion of the second metal portion 15 in a plan view. The protrusion-shaped portion 34a is formed in an L shape that covers the side surface 15b on the wiring connection portion 34b and covers the top surface 15c in a side surface view.

At the tip end of the protrusion-shaped portion 34a in the protrusion direction, a tip end surface 34d which has rectangular shape in a plan view and substantially parallel (or parallel) to the second surface 12c is formed. When the first metal portion 34 is bonded to the second substrate 11, the tip end surface 34d is a portion being contacted with and being bonded to the bonding electrode 11a of the second substrate 11.

Therefore, in the second metal portion 15 of the bonding electrode 32a, one side surface 15b and the top surface 15c are covered with the protrusion-shaped portion 34a, and the side surfaces 15b in the other three directions are exposed on the lateral side.

Inside the substrate body 12d on the lower layer side of the bonding electrode 32a with such a configuration, a wiring portion 36 (wiring) forming a part of the circuit unit (not shown) of the substrate body 12d is provided instead of the wiring portion 16 according to the foregoing embodiment.

The wiring portion 36 includes a wiring body 16c and connection portions 16a and 16b same as in the wiring portion 16 according to the foregoing embodiment.

The wiring portion 36 is different from that of the foregoing first embodiment in that the wiring body 16c is provided in a range in which the second metal portion 15 and the wiring connection portion 34b of the first metal portion 34 overlap, and the connection portion 16a electrically connects the wiring body 16c to the first metal portion 34.

Therefore, the connection portion 16a according to the modified example is provided to penetrate through the insulation layer 12e stacked between the wiring connection portion 34b and the wiring body 16c.

For example, a total of 4 connection portions 16a according to the modified example are arranged in a rectangular shape, as indicated by dotted lines in Fig. 6B.

In the bonding electrode 32a with such a configuration, only the shape of the first metal portion 34 is different from the first metal portion 14 of the bonding electrode 12a according to the foregoing embodiment. Therefore, the hardness of the bonding electrode 32a can be adjusted by changing the shapes or volumes of the second metal portion 15 and the first metal portion 34 as in the bonding electrode 12a, and thus the bonding electrode 32a can be formed through the same semiconductor manufacturing process as the bonding electrode 12a.

The first metal portion 34 can be bonded to the second substrate 11, same as in the foregoing embodiment.

In the first substrate 32 according to the modified example, a composite including the first metal portion 34 and the second metal portion 15 formed of metals that differ in hardness is used as the bonding electrode 32a. Therefore, in the bonding electrode 32a, it is possible to limit damage caused due to the pressurization at the time of the bonding to the second substrate 11 and successfully maintain the deformed shape and the connection state at the time of the bonding.

Since the bonding electrodes 32a can be formed through the semiconductor manufacturing process, the bonding electrodes 32a can be formed minutely and can be provided with high precision even in a semiconductor substrate in which wiring intervals are narrow. Therefore, for example, the first substrate 32 is suitable as a semiconductor substrate for manufacturing a semiconductor device with high wiring density and in which a plurality of bonding electrodes are necessary, such as the solid-state imaging element 3.

In the bonding electrode 32a according to the modified example, the three side surfaces 15b of the second metal portion 15 are not covered with the first metal and are exposed on the lateral side. Therefore, in the second metal portion 15 according to the modified example, the restraint received from the first metal portion 34 is looser than in the case of the bonding electrode 12a.

Therefore, the bonding electrode 32a is easily configured with the lower hardness than the bonding electrode 12a.

### [Third modified example]

Next, a semiconductor substrate according to a third modified example of the embodiment will be described.

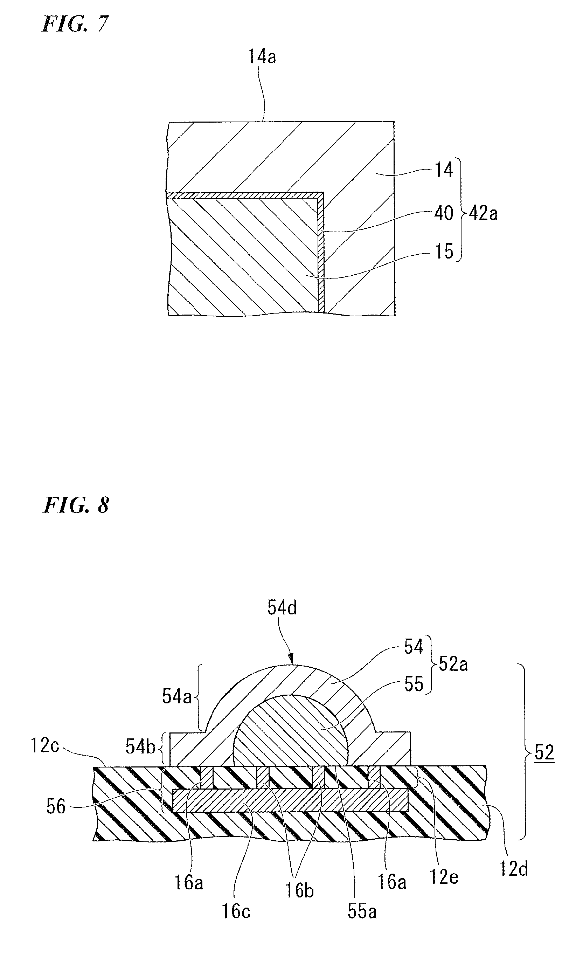

Fig. 7A is a schematic partial sectional view showing a bonding electrode of the semiconductor substrate according to the third modified example of the embodiment of the present invention.

As shown in Figs. 2A and 2B, a first substrate 42 according to the modified example is a semiconductor substrate which can be used for the solid-state imaging element 3, instead of the first substrate 12 according to the foregoing embodiment. The first substrate 42 includes a bonding electrode 42a instead of the bonding electrode 12a according to the foregoing embodiment. Hereinafter, differences from the foregoing embodiment will be mainly described.

Fig. 7 shows the shape of the bonding electrode 42a before deformation. The bonding electrode 42a before deformation is an electrode in which the second metal portion 15 and the first metal portion 14 of the first substrate 12 according to the foregoing embodiment are bonded via a barrier metal layer 40.

The barrier metal layer 40 is a metal layer that limits occurrence of diffusion between the first metal of the first metal portion 14 and the second metal of the second metal portion 15.

As the material of the barrier metal layer 40, a metal appropriate for the prevention of the diffusion can be adopted according to a combination of the first metal and the second metal. For example, in the combination of the metals exemplified in the foregoing embodiment, titanium, chromium, tantalum, or the like can be appropriately adopted.

In the first substrate 42 according to the modified example, the first metal portion 14 and the second metal portion 15 are bonded via the barrier metal layer 40. Therefore, it is possible to prevent deterioration in the performance of the bonding electrode 42a over time occurring due to the diffusion.

### [Fourth modified example]

Next, a semiconductor substrate according to a fourth modified example of the embodiment will be described.

Fig. 8 is a schematic sectional view showing the bonding electrode of a semiconductor substrate according to the fourth modified example of the embodiment of the present invention.

As shown in Figs. 2A and 2B, a first substrate 52 according to the modified example is a semiconductor substrate which can be used for the solid-state imaging element 3, instead of the first substrate 12 according to the foregoing embodiment. The first substrate 52 includes a bonding electrode 52a instead of the bonding electrode 12a of the first substrate 12 according to the foregoing embodiment. Hereinafter, differences from the foregoing embodiment will be mainly described.

Fig. 8 shows the shape of the bonding electrode 52a before deformation. The bonding electrode 52a before deformation includes a first metal portion 54 and a second metal portion 55 instead of the first metal portion 14 and the second metal portion 15 of the bonding electrode 12a according to the foregoing embodiment.

The second metal portion 55 is a protrusion with conductivity provided on the second surface 12c and is formed in a hemisphere in which a bottom surface 55a is in close contact with the second surface 12c.

The second metal portion 55 is formed of the same second metal as the second metal portion 15 according the foregoing embodiment.

The first metal portion 54 includes a wiring connection portion 54b and a hemispheric protrusion-shaped portion 54a. The wiring connection portion 54b extends on the outer circumference side of the base end portion of the second metal portion 55 and is formed as a layered portion with an annular shape which is in close contact with the second surface 12c in a plan view. The protrusion-shaped portion 54a is in close contact with and covers the hemispheric surface of the second metal portion 55, and is connected to the wiring connection portion 54b. An apex portion 54d of the tip end of the protrusion-shaped portion 54a in the protrusion direction is a portion being contacted with and being bonded to the bonding electrode 11a of the second substrate 11 when the fist metal portion 54 is bonded to the second substrate 11.

Inside the substrate body 12d on the lower layer side of the bonding electrode 52a with such a configuration, a wiring portion 56 (wiring) forming a part of the circuit unit (not shown) of the substrate body 12d is provided instead of the wiring portion 16 according to the foregoing embodiment. As in the wiring portion 16 according to the foregoing embodiment, the wiring portion 56 includes a wiring body 16c and connection portions 16a and 16b. The wiring portion 56 is different from that of the foregoing first embodiment in that the wiring body 16c is provided in a range in which the second metal portion 55 and the wiring connection portion 54b of the first metal portion 54 overlap, the connection portion 16b electrically connects the wiring body 16c to the second metal portion 55, and the connection portion 16a electrically connects the wiring body 16c to the first metal portion 54.

Therefore, the connection portions 16b and 16a according to the modified example are provided to penetrate through the insulation layer 12e stacked between the bottom surface 55a of the second metal portion 55 and the wiring connection portion 54b of the first metal portion 54.

The array positions and the numbers of connection portions 16b and 16a according to the modified example are not particularly limited. For example, the plurality of connection portions are arrayed at appropriate intervals on the circumference of a concentric circle of a central axis of the bonding electrode 52a.

In the bonding electrode 52a with such a configuration, only the shapes of the first metal portion 54 and the second metal portion 55 are different from those of the first metal portion 14 and the second metal portion 15 of the bonding electrode 12a according to the foregoing embodiment. Therefore, the hardness of the bonding electrode 22a can be adjusted by changing the shapes or volumes of the second metal portion 55 and the first metal portion 54 as in the bonding electrode 12a, and thus the bonding electrode 52a can be formed through the same semiconductor manufacturing process as the bonding electrode 12a.

When the hemispheric shape of the second metal portion 55 is formed, for example, the second metal is formed in a circular pattern at a position at which the second metal portion 55 is formed and the second metal is heated and melted, and then hardened. In this case, the hemisphere shape is formed by surface tension at the time of the melting.

When the metal is melted at once in this way, the same effect as heat treatment can be obtained, and thus it is possible to reduce the hardness more than before the melting. As in the foregoing embodiment, the first substrate 52 can be bonded to the second substrate 11.

The bonding electrode 52a according to the modified example is different in that the outer appearance of the protrusion-shaped portion 54a is the hemispheric shape while the outer appearance of the bonding electrode 12a according to the foregoing embodiment by the protrusion-shaped portion 14a is the square columnar shape. Therefore, as in the foregoing embodiment, it is possible to limit damage caused due to the pressurization at the time of the bonding to the second substrate 11 and successfully maintain the deformed shape and the connection state at the time of the bonding.

The bonding electrodes 52a can be provided with high precision even in a semiconductor substrate in which wiring intervals are narrow. Therefore, for example, the substrate is suitable as a semiconductor substrate for manufacturing a semiconductor device with high wiring density and in which a plurality of bonding electrodes are necessary, such as the solid-state imaging element 3.

In particular, the outer appearance of the tip end portion in the bonding electrode 52a is the hemispheric shape. Therefore, stress is concentrated on the apex portion 54d at the time of the bonding to the bonding electrode 11a and the deformation is easier.

Even when the bonding electrode 52a is inclined to be pressured to the bonding electrode 11a due to a manufacturing error or an error in a degree of parallelism at the time of the pressurization, the contact distance is not changed, and thus smooth contact can be realized.

### [Fifth modified example]

Next, a semiconductor substrate according to a fifth modified example of the embodiment will be described.

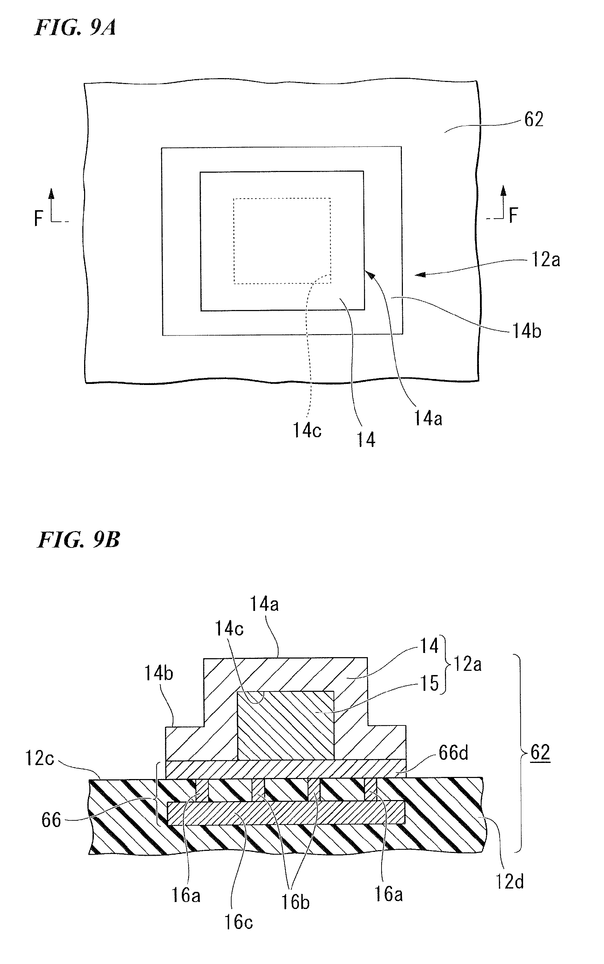

Fig. 9A is a schematic plan view showing a bonding electrode of the semiconductor substrate according to the fifth modified example of the embodiment of the present invention. Fig. 9B is a sectional view taken along the line F-F of Fig. 9A.

As shown in Figs. 2A and 2B, a first substrate 62 according to the modified example is a semiconductor substrate which can be used for the solid-state imaging element 3, instead of the first substrate 12 according to the foregoing embodiment. The first substrate 62 includes a wiring portion 66 (wiring) instead of the wiring portion 16 of the first substrate 12 according to the foregoing embodiment. Hereinafter, differences from the foregoing embodiment will be mainly described.

Figs. 9A and 9B show the shape of the wiring portion 66 before deformation. In the wiring portion 66 before deformation, a connection electrode 66d with a solid pattern is added to the wiring portion 16 according to the foregoing embodiment between the bottom surface of the bonding electrode 12a, and the second surface 12c and the connection portions 16a and 16b. Therefore, all of the connection portions 16a and 16b are electrically connected to the connection electrode 66d. The connection electrode 66d is in close contact with the bottom surface of the first metal portion 14 and the entire bottom surface 15a of the second metal portion 15 to be bonded.

As the material of the connection electrode 66d, an appropriate metal used for the wiring of the semiconductor substrate, for example, a metal formed from aluminum, copper, or gold, can be adopted.

In such a configuration, it is possible to improve reliability of the electric connection to the bonding electrode 12a.

After the connection electrode 66d is formed, the second metal portion 15 and the first metal portion 14 are formed above the layer of the connection electrode 66d. Therefore, since manufacturing can be performed through plating, the second metal portion 15 and the first metal portion 14 can be selectively formed on the connection electrode 66d.

In the description of the foregoing embodiment and each modification, the cases in which the protrusion-shaped portion of the bonding electrode has the square columnar shape and the hemispheric shape have been exemplified, but the shape of the protrusion-shaped portion of the bonding electrode is not limited thereto. For example, not only the square column but also a shape such as a polygonal column, a cylinder, an elliptic cylinder, a pyramid, a truncated pyramid, a cone, a circular cone, or a dome shape of which a hemispheric cross-sectional surface extends in one direction can be adopted.

In the description of the foregoing embodiment and each modification, the cases in which the shape of the second metal portion is the rectangular parallelepiped shape and the hemispheric shape have been exemplified, but the shape of the second metal portion is not limited thereto. For example, a shape such as a polygonal column, a cylinder, an elliptic cylinder, a pyramid, a truncated pyramid, a cone, a circular cone, or a dome shape of which a hemispheric cross-sectional surface extends in one direction can also be adopted. The second metal portion need not come in contact with the surface of the semiconductor substrate body. Therefore, the entire outer circumference of the second metal portion can be covered with the first metal portion. Accordingly, a shape such as a spherical shape or a spheroid shape can also be adopted for the second metal portion.

In the description of the foregoing embodiment and each modification, the case in which the wiring portion is connected directly to the first metal portion and the second metal portion via each connection portion has been exemplified, but the second metal portion is not necessarily connected directly to the wiring portion. However, since the bonding electrode can be electrically connected more reliably and the electric connection can be easily maintained over time, the second metal portion is preferably connected directly to the wiring portion.

In the description of the foregoing embodiment and each modification, the case in which the first substrate including the light-receiving portion P is the semiconductor substrate of the present invention including the bonding electrode which is the composite of the first metal portion and the second metal portion and the second substrate is the bonded member has been exemplified. However, the bonding electrode which is the composite of the first metal portion and the second metal portion can also be provided using the second substrate as the semiconductor substrate according to the present invention, and the bonding electrode of the first substrate can be configured as the bonded member only for the bonding pad.

The bonding electrode of the bonded member is not necessarily the bonding pad, but the bonding electrode which is the composite of the first metal portion and the second metal portion may also be provided in the bonded member. That is, a semiconductor device and an imaging element in which the semiconductor substrates according to the present invention including the bonding electrode which is the composite of the first metal portion and the second metal portion are bonded to each other may be configured.

All of the constituent elements described above may be appropriately combined or omitted within the scope of the technical spirit and essence of the present invention.

For example, the barrier metal layer 40 according to the foregoing third modified example may be provided between the first metal portion and the second metal portion in the foregoing first, second, fourth, and fifth modified examples.

The connection electrode 66d according to the foregoing fifth modified example can be provided in the wiring portion according to the foregoing first to fourth modified examples.

While the embodiment and modified examples of the present invention have been described in detail with reference to the drawings, a specific configuration is not limited to the foregoing embodiments and modified examples, and also includes a change in design without departing from the subject matter of the invention. Further, of course, configurations described in the embodiments may be appropriately combined. In addition, the present invention is not limited to the above-mentioned description but may be limited by the scope of the accompanying claims.

### [Industrial Applicability]

In the semiconductor substrate according to each of the foregoing embodiments, it is possible to provide the semiconductor substrate, the semiconductor device, the image sensor, and the imaging device capable of successfully maintaining deformed shapes and connection states when the electrodes are bonded while limiting damage caused due to pressurization when the electrodes are bonded.

### [Reference Signs List]

- 3: Solid-state imaging element (imaging element)
- 10: Digital camera (imaging device)
- 11: Second substrate (bonded member)
- 11a, 12a, 22a, 32a, 42a, 52a: Bonding electrode
- 11c: First surface (first surface of semiconductor substrate body)
- 11d: Substrate body
- 12, 22, 32, 42, 52: First substrate (Semiconductor substrate body)
- 12d: Substrate body
- 13: Bonding layer portion
- 13a: Adhesive layer
- 14, 24, 34, 54: First metal portion
- 14a, 24a, 34a, 54a: Protrusion-shaped portion
- 14b, 34b, 54b: Wiring connection portion
- 14d, 24d, 34d: Tip end surface
- 15, 55: Second metal portion
- 16, 36, 56, 66: Wiring portion (wiring)
- 16a, 16b: Connection portion
- 16c: Wiring body
- 17: Wiring portion
- 40: Barrier metal layer
- 54d: Apex portion
- 66d: Connection electrode
- P: Light-receiving portion

## Claims

1. A semiconductor substrate comprising:
a semiconductor substrate body in which a wiring is formed; and
a bonding electrode provided to protrude from a first surface of the semiconductor substrate body,
wherein the bonding electrode comprises a composite including
a first metal portion which is provided to protrude from the first surface of the semiconductor substrate body and of which a base end portion in a protrusion direction is electrically connected to the wiring, and
a second metal portion which is formed of a second metal harder than first metal of which the first metal portion is formed and which is provided to be bonded to the first metal portion in a range equal to or less than a protrusion height of the first metal portion.

2. The semiconductor substrate according to claim 1, wherein the second metal portion is covered with the first metal portion at a tip end portion of the bonding electrode in the protrusion direction.

3. The semiconductor substrate according to claim 1 or 2, wherein the bonding electrode is formed by the first metal portion at an entire surface protruding from the first surface of the semiconductor substrate body.

4. The semiconductor substrate according to any one of claims 1 to 3,
wherein the second metal is aluminum, and
the first metal is gold or copper.

5. The semiconductor substrate according to any one of claims 1 to 3,
wherein the second metal is gold, and
the first metal is copper.

6. The semiconductor substrate according to any one of claims 1 to 3,
wherein the second metal is indium, and
the first metal is a metal selected from gold, copper, and aluminum.

7. The semiconductor substrate according to any one of claims 1 to 6, wherein the second metal portion is bonded to the first metal portion via a barrier metal layer.

8. A semiconductor device comprising:
the semiconductor substrate according to any one of claims 1 to 7; and
a bonded member bonded via the bonding electrode of the semiconductor substrate.

9. An imaging element comprising:
the semiconductor substrate according to any one of claims 1 to 7.

10. An imaging device comprising:
the imaging element according to claim 9.
